# EUROPEAN PATENT APPLICATION

(11) **EP 0 561 714 A2**
(43) Date of publication of application: **22.09.1993**
(21) Application number: 93400718.8
(22) Date of filing: 22.03.1993
(51) Int. Cl.: G01R 11/04, H02B 1/03

(54) **Electric utility revenue meter polycarbonate base**

(30) Priority: 20.03.1992 CA 2063618
(71) Applicant: SCHLUMBERGER CANADA LIMITED, Toronto Ontario M4G 3X1 (CA)
(72) Inventor: Hartman, Marinus, Pickering, Ontario, Canada L1W 1G5 (CA)
(74) Representative: Hawkes, David John

(57) **Abstract**

A base for an electric utility watt hour meter made from a polycarbonate material preferably reinforced with glass fibre and ultraviolet light stabilized. The molded base receives current terminals that have outwardly directed wings engaging one face of the base; there are locking arms on the other side of the base resiliently biased against the terminals to engage a locking formation thereon. The base has a knife-edged rib extending about its periphery to sealingly engage a front edge face of a cup shaped transparent cover for the meter. A metal ring joins the cover to the base the metal ring being a band with a first series of tabs struck out and directed inwardly to engage the flange on the cover and a second group of tabs struck outwardly and bent inwardly to engage a bayonet ramp surface on the base.

## Description

### Field of Invention

This invention relates generally to electric utility revenue meters.

### Background of the Invention

Watt hour meters most commonly used as electrical energy revenue meters are the single induction electro-mechanical type. These meters have proven to have a high degree of accuracy and reliability through many years of service under varying ambient operating conditions. These meters have proven so reliable that accrediting authorities in Canada only require sample testing from which a number of meters can be sealed for a period of twelve years and this can be extended for periods of up to eight years indefinitely depending upon the accuracy criteria. The conventional electro-mechanical induction meter lasts in the vicinity of thirty to forty-five years.

The basic components of the meter are assembled on a frame which is mounted on a base; a glass cover attaches to the base to form an enclosure for these basic meter components. The cover is sealed to the base and the cover and base are so designed that it is almost impossible to tamper with the adjustments of the meter without leaving evidence.

The existing meter bases are made from a phenolic material, i.e. Bakelite* , and the current terminals slide through slots in the base. The terminals are held in place by a rubber gasket and metal washer on the inside and a cotter pin through the blade terminal on the outside. Assembly of this structure is labour intensive and requires a number of parts.
* Trade-mark

The current terminals project through the base so that they may mate with the terminal receptacle or meter box normally mounted on the side of the house or building. The terminals therefore provide the electrical connection from the utility distribution network through the meter to the house or building. Current is carried through a current coil and a potential coil in the meter. This induces flux in the electro-magnetic system of the meter to rotate a rotor (disk) in the meter in response to and proportional to the energy being consumed.

In known meters a seal is formed between the glass and the base by an O-ring fitting into a channel in the base adjacent its outer perimeter. This gasket presses against the glass cover to form the seal. As it is necessary to have the gasket loose on the base to form a proper seal, it is sometimes tricky to handle the meter when the glass cover is removed without having the gasket fall out of its channel.

### Summary of the Invention

In accordance with one aspect of the present invention there is provided an electric utility revenue meter box formed from a polycarbonate material. The base preferably has a knife-edge rib near its outer periphery for sealingly engaging a flange around the cup shaped glass cover of the meter.

There is also provided in accordance with the present invention a metal ring for joining a cup-shaped transparent cover to a base of a watt hour meter comprising a flange directed inwardly for engaging an outside face of an outwardly directed flange on the open end of the cup-shaped transparent cover, a first plurality of tabs struck out from said ring and bendable inwardly for engaging an inside face of said cover flange and a second plurality of struck out tabs directed inwardly to engage tapered ramps adjacent an outer periphery of said meter base.

In a further aspect of this invention, there is provided an electro-mechanical induction meter comprising: a base having slots therein with integral locking means associated therewith; a current terminal having a blade received by one of said slots, said current terminal having a formation for locking to said locking means.

### List of Drawings

The invention is illustrated by way of example in the accompanying drawings wherein:
Figure 1 is an exploded, side elevational, view of an electro-mechanical induction watt hour meter made in accordance with the present invention;
Figure 2 is an oblique view of the register and rotary unit of the meter illustrated in Figure 1;
Figure 3 is an oblique view of the base portion of the meter without the coil unit mounted thereon illustrating spacer and mounting lugs for attaching the electro magnetic and register units thereto;
Figure 4 is essentially the same as Figure 3 but with the mounting lugs removed;
Figure 5 is a partial sectional view illustrating sealing engagement of the glass cover with a knife edge rib formed integrally with the molded polycarbonate base;
Figure 6 is an oblique view of the glass cover with a metal ring attached thereto and provided in accordance with the present invention;
Figure 7 is an elevational view of one current coil with a pair of current terminals attached thereto;
Figure 8 is an end elevational view of Figure 7;
Figure 9 is a portion of the meter base with a current terminal anchored thereto; and
Figure 10 is an oblique view of a portion of the meter base illustrating the current terminal prior to being inserted through a hole therefor provided in the base.

### Description of Preferred Embodiments

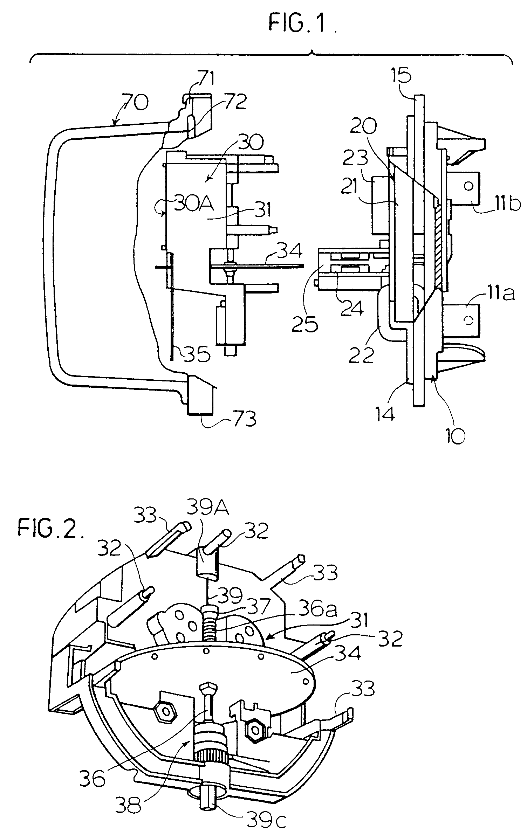

Figure 1 is an exploded view of applicant's electro-mechanical induction watt hour meter the major components of which are a base 10, an electro-magnetic unit 20, a register and rotor unit 30 and a transparent glass cover 70.

The electro-magnetic unit 30 has a core unit 21 with respective current and potential coils 22 and 23 mounted thereon. There are two current coils, one being visible in Figure 1, the other being located behind the visible coil 22. A magnetic disk brake 24 is carried by the unit 20 and has a gap 25 for receiving a portion of a rotor disk 34 which is part of the register and rotor unit 30. The unit 20 securely attaches to the molded base 10 and has pairs of current terminals 11a and 11b projecting therefrom. There are two current terminals for each of the two current coils.

Base 10 is molded from a thermoplastic material in the nature of a polycarbonate material. The base, being molded of a polycarbonate material, is rigid but at the same time displays certain flexibility allowing for constructions and designs not made possible the conventional Bakelite* base. The polycarbonate is preferably class fibre reinforced (roughly 10% glass fibre) and ultraviolet light stabilized. The preferred polycarbonate is identified as #9417 polycarbonate resin available from Bayer Company of Germany under their Trade-Mark Makrolon. The resiliency of the base is relied upon as will become more apparent hereinafter. The magnetic coil unit 20 snap fits onto the base by means of selected ones of a plurality of lugs 16 projecting from the base. There are also spacer and positioning lugs on the base and some of the lugs on the base cooperate with lugs projecting from the housing of the register and rotor unit 30.
* Trade-mark

The register and rotor unit 30 is a module that snap fits onto coil unit 20. Unit 30 includes a molded plastics (Preferably Ryton* PPS) housing 31 having a plurality of spacer lugs 32 projecting therefrom and attaching lugs 33 for precisely locating unit 30 relative to unit 20 and attaching unit 30 to the coil unit 20 mounted on the base.

The unit 30 has a register diagrammatically illustrated by its face designated 30A and a name plate 35 that attaches to and extends downwardly from the molded plastic housing 31. The locating lugs 32 position the unit 30 relative to unit 20 such that, as previously mentioned, disk 34 fits into the gap 25 and lugs 33 snap fasten onto coil unit 20 (and/or base unit 10).

The disc 34 is caused to rotate by the electro-magnetic unit 20 in a known manner. With reference to Figure 2, disk 34, is mounted on a shaft or spindle 36 having respective upper and lower bearing units 37 and 38 on the molded plastic housing unit 31. A pintle 39, associated with the upper bearing 37, projects therefrom into a pintle receiving unit 39A on the molded plastic housing 31. Worm gear 36A on the upper end of rotor shaft 36 meshes with a drive gear (not shown) for the register unit which, via dials, visually indicates the cumulative energy consumed.

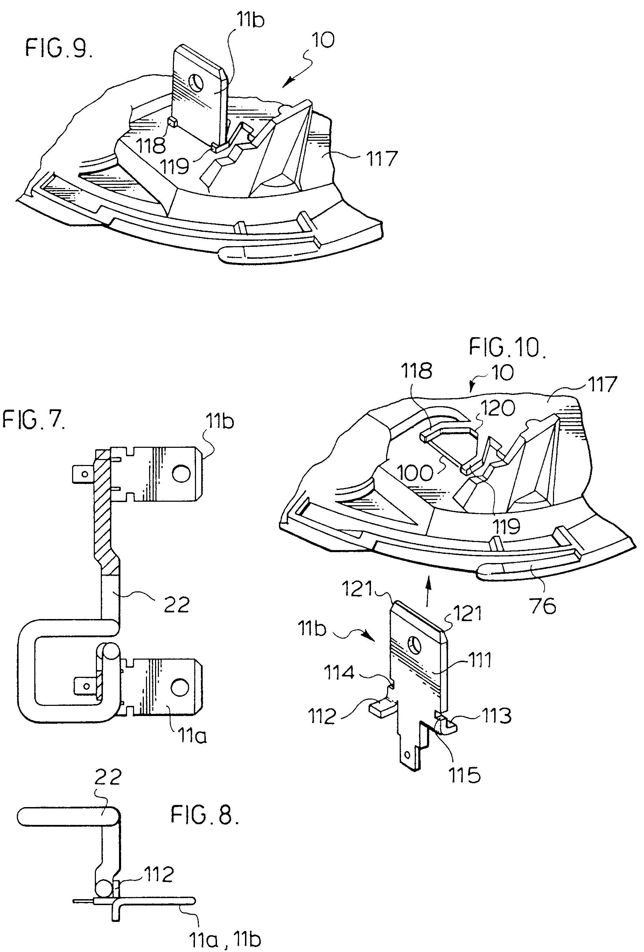

Returning to Figure 1, the glass cover 70 has an outwardly directed flange 71 with a seat portion 72 that abuts against a seal forming knife edge rib 14 on the base 10. The outwardly directed flange 71 carries a metal ring 73 provided with lugs that engage tapered ramps 76 (figure 10) on the flange 15 of the base forming a bayonet type mount whereby the glass cover and base may be rotated relative to one another to detachably join them together with the outer edge of rib 14 on the base being pressed against the seat 72 on the glass cover forming a seal. Indeed, the inclined ramp 76 (figure 10) brings the base and glass cover into tight pressure engagement as one is rotated relative to the other. The resiliency of the material of which base 16 is made permits the forming of a tight seal between the knife edge 14A and the glass cover.

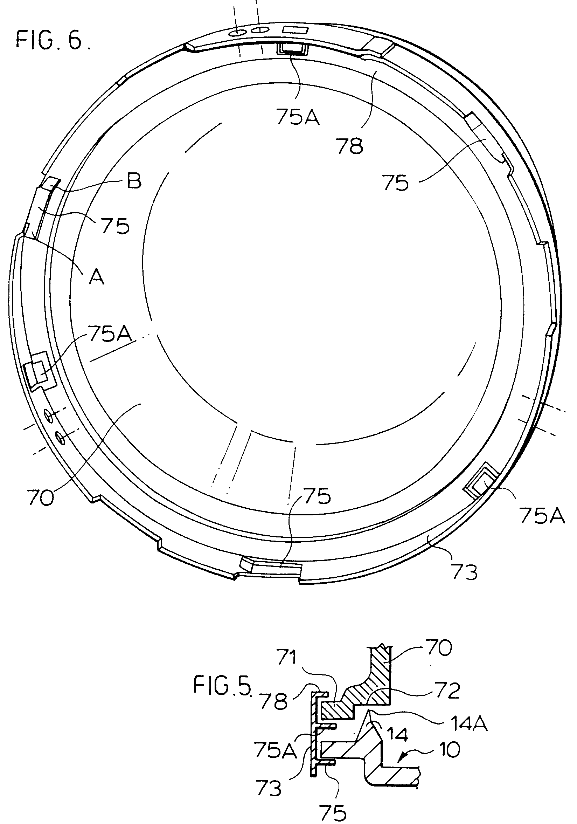

Figure 5 is a partial cross-sectional view through an edge portion of the glass cover 70, metal ring 73 and the base 10 clearly illustrating the peripheral rib 14 as having a knife edge 14A that engages the seat 72 of the glass cover. Figure 5 also illustrates the lugs 75 projecting from ring 73.

The metal ring 73 is illustrated in Figure 6 which in accordance with an aspect of the present invention has a first plurality of tabs 75A struck out from the ring for engaging the inside face of the outwardly directed flange 71 (see figure 5) of the glass cover and a second plurality of struck out tabs 75 for engaging the tapered ramps 76 (figure 10) of the base 10. The tabs 75 and 75A are spaced relative to one another in the direction of the width of the band 73. The metal band has an inwardly directed flange 78 for engaging the outside face of the cover flange 71 to press the flange 71 against tabs 75 (see figure 5).

From Figure 6 it will be observed the struck out tabs 75 have free outer end portions A & B bent inwardly to provide a spring type engagement with the tapered ramp 76 (figure 10) on the base.

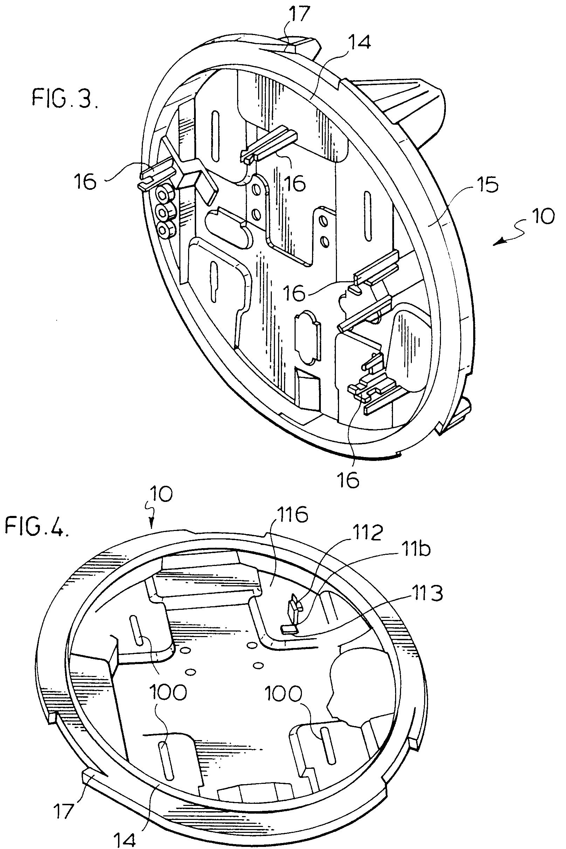

The flexibility of the polycarbonate base is also relied upon for attaching the current terminals and this is discussed with reference to Figures 4 and 7 to 10 inclusive.

Figure 4 illustrates the base 10 without spacer lugs and connecting lugs. The face 116 of the base 10 shown in Figure 4 is the face disposed interiorly of the meter when the base is clamped to the glass cover. The base is formed with four elongated slots 100 for receiving the blades of respective ones of four different blade type current terminals, one 11B of which is illustrated in figure 4 occupying one of the slots. Current terminal 11b has two oppositely directed wings 112 and 113. The wings 112 and 113 bear against the inside face 116 of the base 10 and keep the current terminal from sliding through the slot. This eliminates the need for washers and gaskets as is the case in the prior art. These wines also serve the position the current coil 22 (of figure 1) while it is being brazed to the terminal 11b. One of the two current coils 22 is illustrated in Figures 7 and 8. The other of the two coils is a mirror image of the illustrated coil. The coil is a precision formed copper wire of large cross-sectional area. From figure 8 it will be noted one of the wings 112 of the current terminal 11B bears against a portion of the coil.

Figures 9 and 10 show a portion of the opposite side of base 10 from that shown in Figure 4. Thus, figures 9 and 10 show the face 117 which is disposed exteriorly of the meter.

Figure 10 is an exploded view illustrating a slot 100 for receiving the blade 111 of a current terminal 11b. It will be noted that terminal 111, in addition to wings 112, 113, has notches 114, 115 on opposite edges of the terminal. The notches are spaced from the wings in the direction of the chamfered end 121 of the terminal. Formed integrally with the base 10 is a pair of fingers 118 and 119 which, adjacent their free ends, overlap respective opposite end portions of the slot 100. The fingers 118 and 119 merge into the rest of the base as indicated at 120 and forwardly thereof the fingers are free to move relative to the base. The leading end of the terminal 11b is chamfered at 121 and when the terminal is inserted into the slot, the terminal causes the arms 118 and 119 to flex outwardly. As the terminal is pushed through to a position where the wings 112 and 113 of the terminal engage the inner face 116 (figure 4) of the base, the fingers 118 and 119 snap into respective slots 114 and 115 of the terminal. This securely anchors the current terminal to the base simplifying considerably the assembly compared with the conventionally used prior techniques. Figure 9 illustrates the terminal 11 in its final position with the fingers 118 and 119 seated in the respective slots 114 and 115.

The resiliency of the polycarbonate material from which the base 10 is made allows forming a seal integrally with the base eliminating the need of a separate O-ring as has been the common practice.

The plastics for the molded housing, pilot bearings and meter base are engineering grade resins and preferably rigid thermoplastic materials such as those identified hereinbefore.

## Claims

1. An electric utility revenue meter base formed from a polycarbonate material.

2. A meter base as defined in claim 1 wherein said polycarbonate material is glass fibre reinforced and ultraviolet light stabilized.

3. A base as defined in claim 1 having a knife-edge projection formed integrally therewith, said projection extending about the base adjacent the outer periphery thereof, said knife edged projection for sealingly engaging a flange of a cup shaped cover for the meter.

4. An electro-mechanical induction meter having a base as defined in claim 1, 2 or 3.

5. A meter base as defined in claim 1 having slots therein for receiving respective ones of a plurality of current terminals and locking means molded integrally with the base and engageable with 3 formation on the current terminal associated therewith to lock the same to the base.

6. A meter base as defined in claim 5 wherein said terminal locking means comprises a finger molded integrally with the base and overlapping a portion of the slot associated therewith, said formation on a terminal comprising a detent for receiving said finger to lock the current terminal to the base.

7. A metal ring for joining a cup-shaped transparent cover to a base of a watt hour meter comprising a flange directed inwardly for engaging an outside face of an outwardly directed flange on the open end of the cut-shaped transparent cover, a first plurality of tabs struck out from said ring and bendable inwardly for engaging an inside face of said cover flange and a second plurality of struck out tabs directed inwardly to engage tapered ramps adjacent an outer periphery of said meter base.

8. A meter ring as defined in claim 7 wherein said second plurality of tabs have free outer end portions bent in a ramp engaging direction.

9. An electro-mechanical induction meter comprising:
- a base having slots therein with integral locking means associated therewith;
- a current terminal having a blade received by one of said slots, said current terminal having a formation for locking to said locking means.

10. The meter of claim 9 wherein said integral locking means comprises a resilient finger integrally formed with said base and wherein said formation comprises a notch for receiving said finger.

11. The meter of claim 10 wherein said terminal includes wings for limiting the penetration of said blade through one of said slots.
